# EUROPEAN PATENT APPLICATION

(11) **EP 4 451 347 A1**
(43) Date of publication of application: **23.10.2024**
(21) Application number: 23195162.5
(22) Date of filing: 04.09.2023
(51) Int. Cl.: H01L 31/048

(54) **UV-RESISTANT PHOTOVOLTAIC MODULE**

(30) Priority: 17.04.2023 CN 202310430745
(71) Applicant: Jinko Solar (Haining) Co., Ltd., Haining City, Zhejiang (CN)
(72) Inventor: DAI, Zhigang, JIAXING (CN); CUI, Biao, JIAXING (CN); XIAO, Pengjun, JIAXING (CN)
(74) Representative: DREISS Patentanwälte PartG mbB

(57) **Abstract**

The present disclosure relates to a UV-resistant photovoltaic module. The photovoltaic module includes a cell layer, a back sheet layer, a UV barrier layer, and a connection layer. The back sheet layer is arranged on a backlight side of the cell layer. The UV barrier layer is arranged on a light-facing side of the cell layer, and the UV barrier layer is made of a flexible material. The connection layer is located between the cell layer and the back sheet layer and between the cell layer and the UV barrier layer. The UV barrier layer includes a UV absorbent, and the UV absorbent is one or more of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone.

## Description

### TECHNICAL FIELD

The present disclosure relates to the technical field of photovoltaics, in particular, to a UV-resistant photovoltaic module.

### BACKGROUND

Solar energy is an inexhaustible renewable energy source for human beings. A photovoltaic module is a core part of a solar power generation system and also the most important part of the solar power generation system, with a function of converting solar energy into electrical energy and sending the electrical energy to a storage battery for storage, or to drive a load to operate.

Common photovoltaic modules on the market are crystalline silicon photovoltaic modules, which have high photoelectric conversion efficiency. The crystalline silicon photovoltaic modules are packaged with photovoltaic glass, which is heavy and cannot be folded or bent and cannot fit curved objects. In order to solve the above problems, part of the crystalline silicon photovoltaic modules in the related art use flexible packaging structures to achieve flexible bending of the modules, so that the crystalline silicon photovoltaic modules can fit light-load planes or curved surfaces.

However, the flexible crystalline silicon photovoltaic modules in the related art have poor capability to block UV rays, resulting in a short lifetime in actual outdoor use thereof.

### SUMMARY

The present disclosure provides a UV-resistant photovoltaic module, which can improve capability of the photovoltaic module to block UV rays.

The present disclosure provides a UV-resistant photovoltaic module, wherein the photovoltaic module includes: a cell layer; a back sheet layer arranged on a backlight side of the cell layer; a UV barrier layer made of a flexible material and arranged on a light-facing side of the cell layer; and a connection layer located between the cell layer and the back sheet layer and also located between the cell layer and the UV barrier layer; wherein the UV barrier layer includes a UV absorbent, the UV absorbent is one or more of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone.

In an embodiment, the UV barrier layer is made of a material selecting from one or more of Polyvinyl Fluoride (PVF), Polyvinylidene Difluoride (PVDF), Ethylene-Tetra-Fluoro-Ethylene (ETFE), and Polymethyl Methacrylate (PMMA).

In an embodiment, the connection layer includes a buffer layer, and the buffer layer is located between the UV barrier layer and the cell layer.

In an embodiment, the buffer layer is made of a material selecting from one or more of Polyethylene Terephthalate (PET), PMMA, Polyamide (PA), epoxy resin, and Polycarbonate (PC).

In an embodiment, the connection layer includes a support layer, and the support layer is located between the back sheet layer and the cell layer.

In an embodiment, a thickness D1 of the buffer layer and a thickness D2of the support layer satisfies: 0.5≤D1:D2≤4.

In an embodiment, the connection layer further includes a first adhesive film layer and a second adhesive film layer, the first adhesive film layer covers a surface on the light-facing side of the cell layer, and is further configured to be connected to the buffer layer; the second adhesive film layer covers a surface on the backlight side of the cell layer, and is further configured to be connected to the support layer.

In an embodiment, the first adhesive film layer and the second adhesive film layer have a same gram weight; and the gram weight A of the first adhesive film layer or the second adhesive film layer satisfies: 400 g/m²≤A≤700 g/m².

In an embodiment, the connection layer further includes a first glue layer, the first glue layer is located between the UV barrier layer and the buffer layer; and the first glue layer is an adhesive film or an adhesive.

In an embodiment, when the first glue layer is the adhesive, a thickness D3 of the first glue layer satisfies: 5 µm≤D3≤20 µm.

In an embodiment, the connection layer further includes a second glue layer, the second glue layer is located between the back sheet layer and the support layer; and the second glue layer is an adhesive film or an adhesive.

In an embodiment, when the second glue layer is the adhesive film, the back sheet layer is one of a CPC structural back sheet, a KPC structural back sheet, or a TPC structural back sheet.

In an embodiment, when the second glue layer is the adhesive, the back sheet layer is made of a material selecting from one or more of Polyvinyl Fluoride (PVF), Polyvinylidene Difluoride (PVDF), Ethylene-Tetra-Fluoro-Ethylene (ETFE), and Polymethyl Methacrylate (PMMA).

In an embodiment, both the first glue layer and the second glue layer are adhesive films, and the first glue layer and the second glue layer have a same gram weight; and the gram weight B of the first glue layer or the second glue layer satisfies: 100 g/m²≤B≤500 g/m².

In an embodiment, A and B satisfy: 1≤A:B≤7.

In an embodiment, the back sheet layer is made of a material selecting from one or more of Polyvinylidene Difluoride (PVDF), Chlorotrifluoroethylene (CTFE), and Poly Tetra Fluoroethylene (PTFE); and the back sheet layer is applied to a surface of the support layer.

In the present disclosure, one or more UV additives of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone are added to the material of the UV barrier layer, which can reduce transmittance of the UV barrier layer to UV light, and improve the capability of the photovoltaic module to block UV rays, thereby reducing an influence of the UV rays on the connection layer and the back sheet layer, slowing down aging of the connection layer and the back sheet layer, preventing premature yellowing and decomposition of organic polymer materials in the connection layer and the back sheet layer, and prolonging an effective lifetime of the photovoltaic module in outdoor use.

It should be understood that the foregoing general description and the following detailed description are exemplary only and are not intended to limit the present disclosure.

### BRIEF DESCRIPTION OF DRAWINGS

FIG. 1 is a schematic diagram of a sectional structure of a photovoltaic module according to the present disclosure in some embodiments; and
FIG. 2 is a schematic diagram of a sectional structure of the photovoltaic module according to the present disclosure in some embodiments.

Reference signs:
1: cell layer;
2: back sheet layer;
3: UV barrier layer;
4: connection layer;
   41: buffer layer;
   42: support layer;
   43: first adhesive film layer;
   44: second adhesive film layer;
   45: first glue layer;
   46: second glue layer.

The accompanying drawings herein are incorporated in and constitute a part of this specification, illustrate embodiments consistent with the present disclosure and, together with the specification, serve to explain the principles of the present disclosure.

### DESCRIPTION OF EMBODIMENTS

In order to better understand the technical solutions of the present disclosure, embodiments of the present disclosure are described in detail below with reference to the accompanying drawings.

It is to be made clear that the described embodiments are only some rather than all of the embodiments of the present disclosure. All other embodiments obtained by those of ordinary skill in the art based on the embodiments in the present disclosure without creative efforts fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means that the associated objects are in an "or" relationship.

It is to be noted that the location terms such as "above", "below", "left", and "right" described in the embodiments of the present disclosure are described with reference to the angles shown in the accompanying drawings, and should not be construed as limitations on the embodiments of the present disclosure. In addition, in the context, it is to be further understood that, when one element is referred to as being connected "above" or "below" another element, the one element may be directly connected "above" or "below" another element, or connected "above" or "below" another element via an intermediate element.

In the related art, in order to meet a market demand to enable the crystalline silicon photovoltaic modules to fit curved surfaces or low-load planes, some manufacturers have made improvement on the basis of packaging mechanisms of thin-film photovoltaic modules and launched lightweight and flexible crystalline silicon photovoltaic modules to achieve flexible bending of the crystalline silicon photovoltaic modules, so that the crystalline silicon photovoltaic modules can be adapted to various application scenarios.

In existing lightweight and flexible photovoltaic modules, organic polymer materials such as PET, a Polyolefin Elastomer (POE), and Polyvinyl Butyral (PVB) are used in internal structure layers. Such organic polymer materials cannot withstand long-term outdoor sunlight, and are prone to yellowing and decomposition otherwise. However, due to poor capability of a packaging structure of a flexible photovoltaic module to block UV rays, the internal structure layer is exposed to UV aging for a long time, which seriously affects an effective service life of the photovoltaic module outdoors.

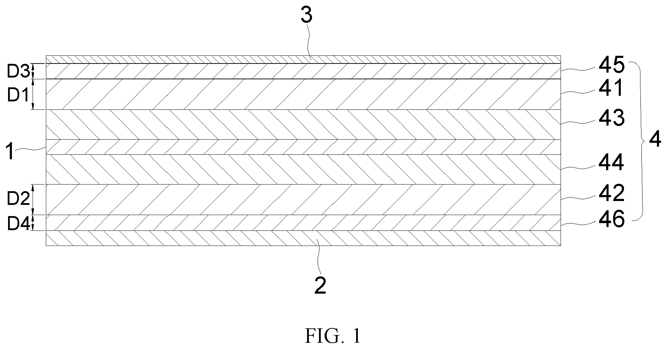

Based on the above, some embodiments of the present disclosure provide a UV-resistant photovoltaic module. As shown in FIG. 1, the photovoltaic module includes a cell layer 1, a back sheet layer 2, a UV barrier layer 3, and a connection layer 4. The back sheet layer 2 is arranged on a backlight side of the cell layer 1. The UV barrier layer 3 is arranged on a light-facing side of the cell layer 1, and the UV barrier layer 3 is made of a flexible material. The connection layer 4 is located between the cell layer 1 and the back sheet layer 2 and between the cell layer 1 and the UV barrier layer 3. A material of the UV barrier layer 3 includes a UV absorbent, the UV absorbent being one or more of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone.

In this embodiment, the cell layer 1, the back sheet layer 2, the UV barrier layer 3, and the connection layer 4 are laminated and packaged and then constitute a photovoltaic module that can be used outdoors for a long time. The cell layer 1 includes a plurality of solar cell strings connected in series or parallel, each solar cell string is composed of a plurality of solar cells (including, but not limited to, monocrystalline silicon solar cells, and polycrystalline silicon solar cells) connected in series, and the solar cells are connected by solder strips. The back sheet layer 2 is located on the backlight side of the cell layer 1 and has functions of water vapor blocking and insulating protection. The UV barrier layer 3 is located on the light-facing side of the cell layer 1, and the UV barrier layer 3 is made of the flexible material, to achieve flexible packaging of the photovoltaic module, so that the photovoltaic module has good bendability to be suitable for application scenarios such as vehicles, curved roofs, and three-dimensional walls. The connection layer 4 is mainly configured to connect and fix the cell layer 1 and the back sheet layer 2 and connect and fix the cell layer 1 and the UV barrier layer 3, and can support and protect the cell layer 1 to some extent, ensuring that the photovoltaic module has good mechanical strength, and reducing influences of conditions such as hail impact, wind blowing, and mechanical vibration.

For example, a UV absorbent is added to the material of the UV barrier layer 3. In this embodiment, the UV absorbent used is a mixture composed of one or more of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone in any proportion. The above UV absorbents are all organic substances with light colors, non-toxicity, strong chemical stability, and strong UV absorption capability, which can ensure that the UV barrier layer 3 has good UV absorption capability. Moreover, the above UV absorbents hardly absorb visible light, which may not affect light transmittance of the UV barrier layer 3 and ensure that more light is irradiated to a surface of the cell layer 1, so as to ensure that photoelectric conversion efficiency of the photovoltaic module is not affected.

According to the photovoltaic module provided in this embodiment, one or more UV additives of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone are added to the material of the UV barrier layer 3, which can reduce transmittance of the UV barrier layer 3 to UV light, and improve the capability of the photovoltaic module to block UV rays, thereby reducing an influence of the UV rays on the connection layer 4 and the back sheet layer 2, slowing down aging of the connection layer 4 and the back sheet layer 2, preventing premature yellowing and decomposition of the organic polymer materials in the connection layer 4 and the back sheet layer 2, and prolonging an effective lifetime of the photovoltaic module in outdoor use.

It is to be noted that the cell layer 1 has two sides arranged opposite to each other, which are a light-facing side and a backlight side of the cell layer 1. The light-facing side refers to a side of the cell layer 1 facing a light source and configured to receive direct sunlight. The backlight side refers to a side of the cell layer 1 facing away from the light source and configured to receive sunlight reflected by the ground.

In one or more embodiments, the material of the UV barrier layer 3 is one or more of PVF, PVDF, ETFE, and PMMA.

In this embodiment, PVF, PVDF, ETFE, and PMMA are all fluorine-containing polymers, with high light transmittance, UV resistance, and chemical stability. The UV barrier layer 3 is a polymer film made of a mixture composed of one or more of the above fluorine-containing polymer in any proportion, which has high light transmittance and is conducive to improving cell conversion efficiency of the photovoltaic module.

For example, a thickness of the UV barrier layer 3 ranges from 10 µm to 50 µm. Within the thickness range, the UV barrier layer 3 has excellent water vapor barrier properties and also has certain mechanical strength to protect the connection layer 4 and the cell layer 1 therein from damages. Moreover, the UV barrier layer 3 with a thickness ranging from 10 µm to 50 µm is used as a packaging structure of the photovoltaic module, which, compared with a conventional glass-packaged photovoltaic module, has a weight that can be reduced by 60%, and can maintain good bendability, so that the photovoltaic module has characteristics of a light weight and flexibility.

In some embodiments, the thickness of the UV barrier layer 3 may be 10 µm, 15 µm, 30 µm, 45 µm, or 50 µm, or may be other values in the above range, which is not limited herein.

In this embodiment, a manufacturing process of the UV barrier layer 3 is as follows: first putting raw material (a mixture composed of one or more of PVF, PVDF, ETFE, and PMMA in any proportion) particles into an ultra-fine pulverizer for pulverization so that particle sizes of powder particles range from 10 µm to 100 µm; then transferring the powder particles to a blender, and adding a UV absorbent (a mixture composed of one or more of 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone in any proportion) at a ratio of 1% to 3%, which are stirred evenly in a heating state at a heating temperature in a range of 80°C to 120°C for 1 h to 5 h; and finally causing a mixed molten material to flow into an extruder and be extruded from a plain-seaming head, so as to obtain the UV barrier layer 3.

In the above manufacturing process, it is to be noted that, for different raw material particles, a melt extrusion temperature varies. The melt extrusion temperatures for PVF and PVDF range from 180°C to 200°C. The melt extrusion temperature for ETFE ranges from 260°C to 280°C. The melt extrusion temperature for PMMA ranges from 160°C to 180°C.

In the photovoltaic module provided in this embodiment, the UV barrier layer 3 is a polymer film modified by the UV absorbent, and transmittance thereof for UV light with a wavelength ranging from 250 nm to 400 nm is less than 3%, which can ensure efficient blocking of the photovoltaic module to the UV light, so as to protect the organic polymer materials in the internal structural layer of the photovoltaic module from damages. The photovoltaic module can pass a 1000 kW•h/m² UV radiation test and achieve a same service life as a conventional crystalline silicon photovoltaic module.

In one or more embodiments, as shown in FIG. 1, the connection layer 4 includes a buffer layer 41, and the buffer layer 41 is located between the UV barrier layer 3 and the cell layer 1.

The buffer layer 41 is located on the light-facing side of the cell layer 1, which can buffer an external impact force and weaken an impact force acting on a light-facing surface of the cell layer 1.

For example, a material of the buffer layer 41 is one or more of PET, PMMA, PA, epoxy resin, and PC.

PET, PMMA, PC, PA, and epoxy resin are all organic polymers with high light transmittance and strong water vapor barrier properties. The buffer layer 41 is a sheet made of a mixture composed of one or more of the above materials in any proportion, which has high light transmittance and low water vapor permeability. When an ambient temperature is 38°C and relative humidity is 85% RH, the water vapor transmission permeability of the buffer layer 41 ranges from 0.1 g/m²/d to 2 g/m²/d. In addition, the above materials also generally have high insulation resistance, which can ensure that a breakdown voltage of the buffer layer 41 is greater than 20 kV, so that the buffer layer 41 can play a role of electrical insulation protection in the photovoltaic module.

For example, a thickness D1 of the buffer layer 41 ranges from 300 µm to 1000 µm. Within the thickness range, transmittance of the buffer layer 41 for incident light with a wavelength ranging from 400 nm to 1100 nm is no less than 86%, which can ensure high light transmittance of the photovoltaic module and is conducive to improving the photoelectric conversion efficiency of the photovoltaic module.

In some embodiments, the thickness D1 of the buffer layer 41 may be 300 µm, 450 µm, 600 µm, 800 µm, or 1000 µm, or may be other values in the above range, which is not limited herein.

In one or more embodiments, as shown in FIG. 1, the connection layer 4 further includes a support layer 42, and the support layer 42 is located between the back sheet layer 2 and the cell layer 1.

The support layer 42 is located on the backlight side of the cell layer 1. The support layer 42 has certain rigidity, and can support the back of the cell layer 1 to prevent the cell layer 1 from excessive deformation under an impact.

In this embodiment, a material of the support layer 42 is a glass fiber reinforced polymer sheet, which may be, for example, one of a glass fiber reinforced PP board, a glass fiber reinforced PET board, a glass fiber reinforced acrylic resin board, a glass fiber prepreg, and a glass fiber reinforced epoxy resin board. A thickness D2 of the support layer 42 ranges from 200 µm to 1000 µm. The support layer 42 within the thickness range helps to improve mechanical strength of the photovoltaic module, without causing an overall thickness of the photovoltaic module to be excessively large.

In some embodiments, the thickness D2 of the support layer 42 may be 200 µm, 400 µm, 650 µm, 900 µm, or 1000 µm, or may be other values in the above range, which is not limited herein.

The thickness D1 of the buffer layer 41 ranges from 300 µm to 1000 µm, and the thickness D2 of the support layer 42 ranges from 200 µm to 1000 µm. On this basis, D1 and D2 should further satisfy: 0.5≤D1:D2≤4. For example, D1:D2 may be 0.5, 1, 2.5, 3.5, 4, or other values within the above range.

In this embodiment, when D1:D2 is excessively small (e.g., less than 0.5), the thickness D1 of the buffer layer 41 is required to be less than 500 µm. Since the thickness of the buffer layer 41 is relatively small, a buffering effect thereof on the impact force is weak, which is applied to a situation where the photovoltaic module is subjected to a small external impact force. In this case, the photovoltaic module also has a low requirement on rigidity of the support layer 42. However, when D1:D2<0.5, the thickness D2 of the support layer 42 is required to satisfy D2>600 µm. That is, the thickness of the support layer 42 is relatively large, which may lead to a waste of materials.

When D1:D2 is excessively large (e.g., greater than 4), the thickness D2 of the support layer 42 is required to be less than 250 µm. Since the thickness of the support layer 42 is relatively small, rigidity thereof is relatively weak, which is applied to a situation where the photovoltaic module is subjected to a small external impact force. In this case, the photovoltaic module also has a low requirement on impact resistance of the buffer layer 41. However, when D1:D2>4, the thickness D1 of the buffer layer 41 is required to satisfy D1>800 µm. That is, the thickness of the buffer layer 41 is relatively large, which may also lead to a waste of materials.

Therefore, when D1:D2 ranges from 0.5 to 4, the requirements of the photovoltaic module on the impact resistance of the buffer layer 41 and on the rigidity of the support layer 42 can be met, and a waste of materials can be prevented, saving the cost. In one or more embodiments, as shown in FIG. 1, the connection layer 4 further includes a first adhesive film layer 43 and a second adhesive film layer 44. The first adhesive film layer 43 covers a surface on the light-facing side of the cell layer 1, and the first adhesive film layer 43 is further configured to be connected to the buffer layer 41. The second adhesive film layer 44 covers a surface on the backlight side of the cell layer 1, and the second adhesive film layer 44 is further configured to be connected to the support layer 42.

In this embodiment, the first adhesive film layer 43 and the second adhesive film layer 44 cover a light-facing surface and a backlight surface of the cell layer 1 respectively, which is used to realize fixed connection between the cell layer 1 and the buffer layer 41 and between the cell layer 1 and the support layer 42 on the one hand. On the other hand, the first adhesive film layer 43 and the second adhesive film layer 44 can jointly protect the cell layer 1, which reduces a risk of hidden cracks of the cell layer 1 during lamination of the photovoltaic module, and helps to improve a yield of the photovoltaic module.

For example, materials of the first adhesive film layer 43 and the second adhesive film layer 44 may be mixtures composed of one or more of materials such as an Ethylene-Vinyl Acetate Copolymer (EVA), Polyolefin Elastomer (POE), Polyvinyl Butyral (PVB), and acrylic resin in any proportion. The above materials all have good thermoplasticity, which is conducive to improving stability of the connection between the cell layer 1 and the buffer layer 41 and between the cell layer 1 and the support layer 42.

In one or more embodiments, gram weights of the first adhesive film layer 43 and the second adhesive film layer 44 are equal; and the gram weights A of the first adhesive film layer 43 and the second adhesive film layer 44 satisfy: 300 g/m²≤A≤700 g/m².

The gram weight refers to a weight of a material per square meter. Since the materials of the first adhesive film layer 43 and the second adhesive film layer 44 are the same, thicknesses of the first adhesive film layer 43 and the second adhesive film layer 44 are also the same when the gram weights of the first adhesive film layer 43 and the second adhesive film layer 44 are equal. For example, the gram weights A of the first adhesive film layer 43 and the second adhesive film layer 44 range from 300 g/m² to 700 g/m². When the gram weights are within the range, lack of glue can be prevented, bubbles during the lamination of the photovoltaic module can be prevented, to achieve a packaging requirement on the cell layer 1, and the first adhesive film layer 43 and the second adhesive film layer 44 can be ensured with sufficient thicknesses, to protect the cell layer 1 from damages during the lamination. At the same time, when the gram weights A do not exceed 700 g/m², the thicknesses of the first adhesive film layer 43 and the second adhesive film layer 44 may not be excessive, which can prevent a waste of materials.

In some embodiments, the gram weights A of the first adhesive film layer 43 and the second adhesive film layer 44 may be 300 g/m², 400 g/m², 550 g/m², 600 g/m², or 700 g/m², or may be other values within the above range, which is not limited herein.

In one or more embodiments, as shown in FIG. 1, the connection layer 4 further includes a first glue layer 45. The first glue layer 45 is located between the UV barrier layer 3 and the buffer layer 41 and configured to fixedly connect the UV barrier layer 3 and the buffer layer 41. The first glue layer 45 is an adhesive film or an adhesive.

When the first glue layer 45 is the adhesive, a thickness D3 of the first glue layer 45 satisfies: 5 µm≤03≤20 µm.

The first glue layer 45 is located on the light-facing side of the cell layer 1, and high light transmittance is required. Therefore, the adhesive is a transparent glue material, which is generally a mixture composed of one or more of composite polyurethane, acrylic ester, epoxy resin, and ethylene-vinyl acetate in any proportion.

The adhesive is laid on a side surface of the UV barrier layer 3 facing the cell layer 1 and/or a side surface of the buffer layer 41 away from the cell layer 1. To ensure strength of connection between the UV barrier layer 3 and the buffer layer 41, a laying thickness D3 of the adhesive should range from 5 µm to 20 µm. In some embodiments, the laying thickness D3 of the adhesive may be 5 µm, 10 µm, 12 µm, 18 µm, or 20 µm, or may be other values within the above range, which is not limited herein.

When the first glue layer 45 is an adhesive film layer, high light transmittance is also required. Therefore, the adhesive film layer requires a material with high light transmittance, which is generally a mixture composed of one or more of EVA, POE, PVB, and acrylic resin in any proportion.

To ensure strength of connection between the UV barrier layer 3 and the buffer layer 41 and prevent a waste of materials, a gram weight of the adhesive film layer ranges from 100 g/m² to 500 g/m². In some embodiments, the gram weight of the adhesive film layer may be 100 g/m², 210 g/m², 350 g/m², 480 g/m², or 500 g/m², or may be other values within the above range, which is not limited herein.

In one or more embodiments, as shown in FIG. 1, the connection layer 4 further includes a second glue layer 46. The second glue layer 46 is located between the back sheet layer 2 and the support layer 42 and configured to fixedly connect the back sheet layer 2 and the support layer 42. The second glue layer 46 is an adhesive film or an adhesive.

When the second glue layer 46 is the adhesive, the material of the back sheet layer 2 is one or more of PVF, PVDF, ETFE, and PMMA.

A material of the adhesive is generally a mixture composed of one or more of composite polyurethane, acrylic ester, epoxy resin, and ethylene-vinyl acetate in any proportion. The adhesive is laid on a side surface of the back sheet layer 2 facing the cell layer 1 and/or a side surface of the support layer 42 away from the cell layer 1. To ensure strength of connection between the back sheet layer 2 and the support layer 42, a laying thickness D4 of the adhesive should range from 5 µm to 20 µm. In some embodiments, the laying thickness D4 of the adhesive may be 5 µm, 10 µm, 12 µm, 18 µm, or 20 µm, or may be other values within the above range, which is not limited herein.

In addition, when the second glue layer 46 is the adhesive, the back sheet layer 2 is generally a polymer film made of a mixture composed of one or more of PVF, PVDF, ETFE, and PMMA in any proportion. The above materials have good ductility, and have high adhesion with the adhesive, which further improves strength of the connection between the back sheet layer 2 and the support layer 42. In this case, the thickness of the back sheet layer 2 ranges from 10 µm to 50 µm, which may be, for example, 10 µm, 15 µm, 30 µm, 45 µm, or 50 µm, or may be other values in the above range, which is not limited herein.

When the second glue layer 46 is the adhesive film, the back sheet layer 2 is one of a CPC structural back sheet, a KPC structural back sheet, and a TPC structural back sheet.

A material of the adhesive film is generally a mixture composed of one or more of EVA, POE, PVB, and acrylic resin in any proportion. To ensure the strength of the connection between the back sheet layer 2 and the support layer 42 and prevent a waste of materials, a gram weight of the adhesive film layer ranges from 100 g/m² to 500 g/m². In some embodiments, the gram weight of the adhesive film layer may be 100 g/m², 210 g/m², 350 g/m², 480 g/m², or 500 g/m², or may be other values within the above range, which is not limited herein.

In addition, when the second glue layer 46 is the adhesive film, the back sheet layer 2 is generally one of a CPC structural back sheet (using PET as a base material, coated with fluororesin on two sides), a KPC structural back sheet (using PET as a base material, coated with fluororesin on one side), and a TPC structural back sheet (using PET as a base material, coated with fluororesin on one side). Adhesion between the above back sheets and the adhesive film is relatively high, which further improves the strength of the connection between the back sheet layer 2 and the support layer 42. Moreover, the above back sheet structures have excellent weather resistance and sufficient structural strength, and can also have functions of water vapor blocking and insulating protection, which is conducive to prolonging the service life of the photovoltaic module. In this case, the thickness of the back sheet layer 2 ranges from 100 µm to 400 µm, which may be, for example, 100 µm, 150 µm, 200 µm, 350 µm, or 400 µm, or may be other values in the above range, which is not limited herein.

In one or more embodiments, the first glue layer 45 and the second glue layer 46 are both adhesive films, and have equal gram weights. That is, the gram weights of the first glue layer 45 and the second glue layer 46 are both B, and the gram weights B range from 100 g/m² to 500 g/m². When the gram weights B are within the range, lack of glue can be prevented, and bubbles during the lamination of the photovoltaic module can be prevented, so as to ensure stable connection between the UV barrier layer 3 and the buffer layer 41 and between the back sheet layer 2 and the support layer 42. At the same time, when the gram weights B do not exceed 500 g/m², the thicknesses of the first glue layer 45 and the second glue layer 46 may not be excessive, which can prevent a waste of materials.

The gram weights A of the first adhesive film layer 43 and the second adhesive film layer 44 range from 300 g/m² to 700 g/m², and the gram weights B of the first glue layer 45 and the second glue layer 46 range from 100 g/m² to 500 g/m². On this basis, A:B should further satisfy: 1≤A:B≤7. For example, A:B may be 1, 2.5, 4.6, 6.8, 7, or other values within the above range.

The first adhesive film layer 43 and the second adhesive film layer 44 play a connection role in the photovoltaic module, and can also play an impact-resistant role to protect the cell layer 1, while the first glue layer 45 and the second glue layer 46 mainly play a connection role. Therefore, a ratio of the gram weights A of the first adhesive film layer 43 and the second adhesive film layer 44 to the gram weights B of the first glue layer 45 and the second glue layer 46 should range from 1 to 7, so as to ensure that the first adhesive film layer 43 and the second adhesive film layer 44 have good impact resistance.

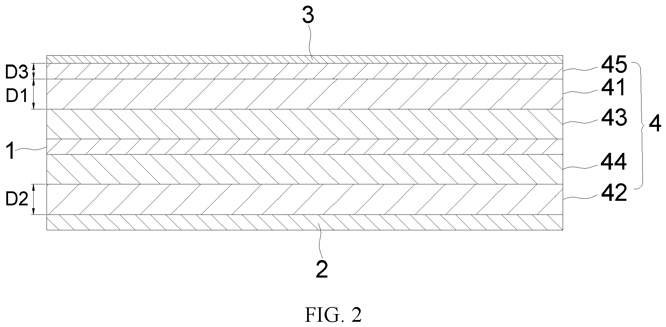

In one or more embodiments, the material of the back sheet layer 2 is one or more of PVDF, CTFE, and PTFE. As shown in FIG. 2, the back sheet layer 2 is applied to a surface of the support layer 42.

In this embodiment, the back sheet layer 2 is directly formed on the surface of the support layer 42. That is, there is no need to arrange the second glue layer 46 between the support layer 42 and the back sheet layer 2, which can simplify a manufacturing process of the photovoltaic module. Moreover, the back sheet layer 2 is a fluorine coating, and made of a mixture composed of one or more of PVDF, CTFE, and PTFE in any proportion. The above materials have good thermoplasticity, can be directly applied to a surface of the support layer 42 away from the cell layer 1, and then undergo heat curing treatment to finally form the back sheet layer 2 in the form of a fluorine coating. The back sheet layer 2 having the structure has strong weather resistance and sufficient structural strength, which is conducive to prolonging the lifetime of the photovoltaic module in actual outdoor use.

In this case, the thickness of the back sheet layer 2 ranges from 10 µm to 30 µm, which can further reduce the thickness of the photovoltaic module compared with the back sheet layer 2 made of other materials. In some embodiments, the thickness of the back sheet layer 2 may be 10 µm, 15 µm, 20 µm, 25 µm, or 30 µm, or may be other values in the above range, which is not limited herein.

Based on the above, the photovoltaic module has the following six structures. (I) The first glue layer 45 is an adhesive, the second glue layer 46 is an adhesive, and the back sheet layer 2 is a fluoro-polymer film. (II) The first glue layer 45 is an adhesive, the second glue layer 46 is an adhesive film, and the back sheet layer 2 is one of a CPC structural back sheet, a KPC structural back sheet, and a TPC structural back sheet. (III) The first glue layer 45 is an adhesive, the second glue layer 46 is not provided, and the back sheet layer 2 is made of one or more of vinylidene chloride, CTFE, and tetrafluoro-resin and is directly applied to the surface of the support layer 42. (IV) The first glue layer 45 is an adhesive film, the second glue layer 46 is an adhesive, and the back sheet layer 2 is a fluoro-polymer film. (V) The first glue layer 45 is an adhesive film, the second glue layer 46 is an adhesive film, and the back sheet layer 2 is one of a CPC structural back sheet, a KPC structural back sheet, and a TPC structural back sheet. (VI) The first glue layer 45 is an adhesive film, the second glue layer 46 is not provided, and the back sheet layer 2 is made of one or more of vinylidene chloride, CTFE, and tetrafluoro-resin and is directly applied to the surface of the support layer 42.

The above are merely preferred embodiments of the present disclosure and are not intended to limit the present disclosure. For those skilled in the art, the present disclosure may be subject to various changes and variations. Any modification, equivalent replacement, improvement, and the like made within the spirit and principles of the present disclosure shall fall within the protection scope of the present disclosure.

## Claims

1. A UV-resistant photovoltaic module, comprising:
a cell layer (1);
a back sheet layer (2), arranged on a backlight side of the cell layer (1);
a UV barrier layer (3), made of a flexible material and arranged on a light-facing side of the cell layer (1); and
a connection layer (4), located between the cell layer (1) and the back sheet layer (2) and also located between the cell layer (1) and the UV barrier layer (3),
wherein the UV barrier layer (3) comprises a UV absorbent, and the UV absorbent is one or more of: 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone.

2. The photovoltaic module according to claim 1, wherein the UV barrier layer (3) is made of a material selecting from one or more of: Polyvinyl Fluoride (PVF), Polyvinylidene Difluoride (PVDF), Ethylene-Tetra-Fluoro-Ethylene (ETFE), and Polymethyl Methacrylate (PMMA).

3. The photovoltaic module according to claim 1, wherein the connection layer (4) comprises a buffer layer (41), and the buffer layer (41) is located between the UV barrier layer (3) and the cell layer (1).

4. The photovoltaic module according to claim 3, wherein the buffer layer (41) is made of a material selecting from one or more of: Polyethylene Terephthalate (PET), PMMA, Polyamide (PA), epoxy resin, and Polycarbonate (PC).

5. The photovoltaic module according to claim 3, wherein the connection layer (4) further comprises a support layer (42), and the support layer (42) is located between the back sheet layer (2) and the cell layer (1).

6. The photovoltaic module according to claim 5, wherein a thickness D1 of the buffer layer (41) and a thickness D2 of the support layer (42) satisfies: 0.5≤D1:D2≤4.

7. The photovoltaic module according to claim 5, wherein the connection layer (4) further comprises a first adhesive film layer (43) and a second adhesive film layer (44),
wherein the first adhesive film layer (43) covers a surface on the light-facing side of the cell layer (1), and is further configured to be connected to the buffer layer (41);
the second adhesive film layer (44) covers a surface on the backlight side of the cell layer (1), and is further configured to be connected to the support layer (42).

8. The photovoltaic module according to claim 7, wherein the first adhesive film layer (43) and the second adhesive film layer (44) have a same gram weight; and
the gram weight A of the first adhesive film layer (43) or the second adhesive film layer (44) satisfies: 400 g/m²≤A≤700 g/m².

9. The photovoltaic module according to claim 8, wherein the connection layer (4) further comprises a first glue layer (45), the first glue layer (45) is located between the UV barrier layer (3) and the buffer layer (41); and
the first glue layer (45) is an adhesive film or an adhesive.

10. The photovoltaic module according to claim 9, wherein the first glue layer (45) is the adhesive, and a thickness D3 of the first glue layer (45) satisfies: 5 µm≤D3≤20 µm.

11. The photovoltaic module according to claim 9, wherein the connection layer (4) further comprises a second glue layer (46), the second glue layer (46) is located between the back sheet layer (2) and the support layer (42); and
the second glue layer (46) is an adhesive film or an adhesive.

12. The photovoltaic module according to claim 11, wherein the second glue layer (46) is the adhesive film, and the back sheet layer (2) is one of a CPC structural back sheet, a KPC structural back sheet, or a TPC structural back sheet.

13. The photovoltaic module according to claim 11, wherein both the first glue layer (45) and the second glue layer (46) are adhesive films, and the first glue layer (45) and the second glue layer (46) have a same gram weight; and
the gram weight of the first glue layer (45) or the second glue layer (46) satisfies: 100 g/m²≤B≤500 g/m².

14. The photovoltaic module according to claim 13, wherein A and B satisfy: 1≤A:B≤7.

15. A method for manufacturing the photovoltaic module according to claim 1, comprising,
laminating and packaging the back sheet layer (2), the cell layer (1), the UV barrier layer (3), and the connection layer (4); wherein
the UV barrier layer (3) is prepared by:
subjecting raw material particles to pulverization to form powder particles; then blending the powder particles with a UV absorbent for stirring evenly in a heating state to obtain a mixed molten material, and extruding the mixed molten material to obtain the UV barrier layer 3, wherein
the UV absorbent is one or more of: 2-(2'-hydroxy-3',5'-di-tert-phenyl)-5-chloro benzotriazole, 2-(2'-hydroxy-5'-methylphenyl)benzotriazole, 2-hydroxy-4-n-octoxyl benzophenone, and 2-hydroxy-4-methoxy benzophenone.
